# EUROPÄISCHE PATENTSCHRIFT

(11) **EP 3 298 347 B1**
(45) Veröffentlichungstag und Bekanntmachung des Hinweises auf die Patenterteilung: **23.09.2020**
(21) Anmeldenummer: 16715471.5
(22) Anmeldetag: 21.03.2016
(51) Int. Cl.: G01B 11/275

(54) **SYSTEM UND VERFAHREN ZUR DURCHFÜHRUNG VON EINSTELLARBEITEN AN EINEM KRAFTFAHRZEUG**
SYSTEM AND METHOD FOR CARRYING OUT ADJUSTMENT OPERATIONS ON A MOTOR VEHICLE
SYSTÈME ET PROCÉDÉ POUR RÉALISER DES OPÉRATIONS DE RÉGLAGE SUR UN VÉHICULE AUTOMOBILE

(30) Priorität: 20.05.2015 DE 102015209246
(43) Veröffentlichungstag der Anmeldung: 28.03.2018
(73) Patentinhaber: Beissbarth GmbH, 80993 München (DE)
(72) Erfinder: KEMPIN, Marco Oliver, 85241 Hebertshausen/Unterweilbach (DE); LUMERA, Juergen, 85411 Hohenkammer (DE); WITKAMP, Jan, 80339 München (DE); LEGEN, Johann, 82541 Muensing (DE); WAGMANN, Christian, 80538 München (DE)
(74) Vertreter: Schmitt-Nilson Schraud Waibel Wohlfrom Patentanwälte Partnerschaft mbB
(86) Internationale Anmeldenummer: PCT/EP2016/056081
(87) Internationale Veröffentlichungsnummer: WO 2016/184589

(56) Entgegenhaltungen:
- EP-A1- 2 302 318
- DE-A1- 4 435 484
- DE-A1-102011 087 177
- US-A1- 2010 321 674

## Beschreibung

### Stand der Technik

Die Erfindung betrifft ein System und ein Verfahren zur Durchführung von Einstellarbeiten an einem Kraftfahrzeug.

Ein Kraftfahrzeug wird regelmäßig in der Werkstatt auf korrekte Spur oder Sturzwerte überprüft. Diese Werte können durch eine Achsvermessungseinrichtung ermittelt werden. Aktuell nimmt ein Service-Techniker abhängig von den durch die Achsvermessungseinrichtung ermittelten Werten Einstellarbeiten an dem Fahrzeug statt. Da sich der Service-Techniker bei diesen Arbeiten unter dem Fahrzeug befindet, ist ein Austausch zwischen der Achsvermessungseinrichtung und dem Service-Techniker, während der Einstellarbeiten unter Umständen nur eingeschränkt möglich.

US 2010/0321674 A1 offenbart eine Vorrichtung und ein Verfahren zum Überprüfen der Lage eines Fahrzeugs mit mindestens einem Messgerät zum Messen mindestens eines charakteristischen Lageparameters. Das Messgerät ist an Bord einer selbstfahrenden Einheit installiert, die sich autonom auf dem Boden bewegt, um variablen Trajektorien zu folgen. Die Vorrichtung umfasst eine Videokamera, die zur Aufnahme des Fahrzeugs ausgebildet ist, und eine Wiedergabeeinrichtung zur Wiedergabe der von der Kamera aufgenommenen Bilder.

### Offenbarung der Erfindung

Es ist eine Aufgabe der Erfindung ein System und ein Verfahren zur Durchführung von Einstellarbeiten an einem Kraftfahrzeug bereit zu stellen. Bei herkömmlichen Systemen und Verfahren besteht keine Interaktion zwischen der Achsvermessungseinrichtung und den Reparaturleitfäden, die ein Anwender eventuell zu Rate zieht, um Einstellungen z.B. an der Spur vorzunehmen.

Ein Anwender kann durch eine Achsvermessungseinrichtung Spur und/oder Sturz eines Kraftfahrzeuges bestimmen und dann Reparaturleitfäden, die in Papierform vorliegen oder elektronisch zur Verfügung stehen, zur Rate ziehen. Nach der Durchführung der Einstellarbeiten muss der Anwender erneut eine Achsvermessung durchführen, um sicherzustellen, dass er korrekt gearbeitet hat.

Die Erfindung gemäß dem unabhängigen Systemanspruch 1 und dem unabhängigen Verfahrensanspruch 5 ermöglicht ein komfortableres Arbeiten des Monteurs, da ein direkter Austausch von Daten der Achsvermessungseinrichtung und einer Wiedergabeeinrichtung besteht. Die Wiedergabeeinrichtung erfüllt hierbei die Funktion eines Reparaturleitfadens mit zusätzlichen Funktionen, da der Anwender abhängig vom aktuellen Arbeitsvorgang über den nachfolgenenden Arbeitsschritt gezielt informiert wird.

Die Information kann dabei so detailliert sein, dass der Anwender über die Drehrichtung einer Schraube informiert wird.

Fehler bei der Durchführung der Einstellarbeiten werden vermieden, da dem Anwender direkt mitgeteilt werden kann, wenn er eine Schraube in die falsche Richtung bewegt, bzw. eine Variation des Spurwertes in die falsche Richtung vornimmt. Da das Achsvermessungsgerät direkt mit der Datenverarbeitungseinheit kommuniziert, kann dem Anwender eine falsche Ausführung eines Arbeitsvorganges direkt mitgeteilt werden. Dadurch kann vermieden werden, dass der Anwender die gesamten Einstellarbeiten nochmal durchführen muss, wenn er den Fehler erst nach dem Abschluss der Arbeiten bemerkt.

Vorteilhaft ist ein Wiedergabemittel in Form einer Datenbrille, da in diesem Fall der Anwender nicht ständig seine Blickrichtung zwischen Wiedergabemittel und Kraftfahrzeug verändern muss. Der Anwender ist weniger abgelenkt und kann sich besser auf den aktuellen Arbeitsvorgang und den nächsten Arbeitsschritt konzentrieren.

Ein Eingabemittel zur Interaktion eines Benutzers mit dem System ist von Vorteil, da dem System durch das Eingabemittel Informationen mitgeteilt werden können, die eventuell nicht allein durch die Bilder der Kameras bestimmt werden könnten. Eventuell ist ein bestimmter Fahrzeugtyp nicht durch das System erkennbar, so dass eine direkte Eingabe des Fahrzeugtyps durch den Benutzer sinnvoll ist. Hierbei ist das Eingabemittel vorteilhaft durch manuelle, visuelle und/oder auditive Interaktion steuerbar.

Einen besonderen Vorteil bietet das Verfahren, wenn ein Vergleich der Bilder mit Bildinformationen über Kraftfahrzeuge durchgeführt wird, welcher zur Identifikation des Kraftfahrzeuges, an dem Einstellarbeiten durchgeführt werden, dient. Durch eine Identifikation des Kraftfahrzeuges durch das System können Fehleingaben des Benutzers vermieden werden. Findet am Anfang der Einstellarbeiten eine manuelle und fehlerhafte Fahrzeugidentifikation durch den Benutzer statt, so berechnet das System einen falschen Sollwert für die Spur und die gesamten Einstellarbeiten werden fehlerhaft durchgeführt. Wird die Identifikation des Kraftfahrzeuges automatisch durch das System durchgeführt, kann ein Fehler des Benutzers korrigiert werden und es werden dem Benutzer die korrekten Arbeitsschritte mitgeteilt. Hierbei ist es von Vorteil, wenn die Darstellung von Dokumentationen und/oder Bildern und/oder Bildinformationen über Einstellarbeiten und nachfolgende Arbeitsschritte unter Berücksichtigung der Identifikation des Kraftfahrzeuges erfolgt.

Vorteilhaft ist eine periodische und/oder kontinuierliche und/oder wiederholte Vermessung des Kraftfahrzeuges durch die Achsvermessungseinrichtung, während die Einstellarbeiten durchgeführt werden, wobei die jeweiligen Achsvermessungsdaten an die Datenverarbeitungseinrichtung gesendet werden. Hier kann das System schnell einen Fehler bei der Durchführung der Einstellarbeiten feststellen, wenn sich die Achsvermessungsdaten nicht in die gewünschte Richtung verändern.

Um den Anwender immer über den aktuellen Stand der Einstellarbeiten am Fahrzeug zu informieren, ist eine Darstellung von Dokumentationen und/oder Bildern und/oder Bildinformationen über Einstellarbeiten und nachfolgende Arbeitsschritte in dem Wiedergabemittel, die abhängig von den jeweiligen Achsvermessungsdaten und/oder den jeweiligen Bildern über einen oder mehrere Arbeitsvorgänge aktualisiert werden, von Vorteil.

### Ausführungsbeispiele

Bevorzugte Ausführungsbeispiele der Erfindung sind in der Zeichnung dargestellt und in der nachfolgenden Beschreibung näher erläutert.

Es zeigen:
Figur 1 ein Ausführungsbeispiel eines Systems zur Durchführung von Einstellarbeiten an einem Kraftfahrzeug und
Figur 2 eine Flussablaufdiagram mit den Schritten eines Verfahrens zur Durchführung von Einstellarbeiten an einem Kraftfahrzeug.

### Ausführungsformen der Erfindung

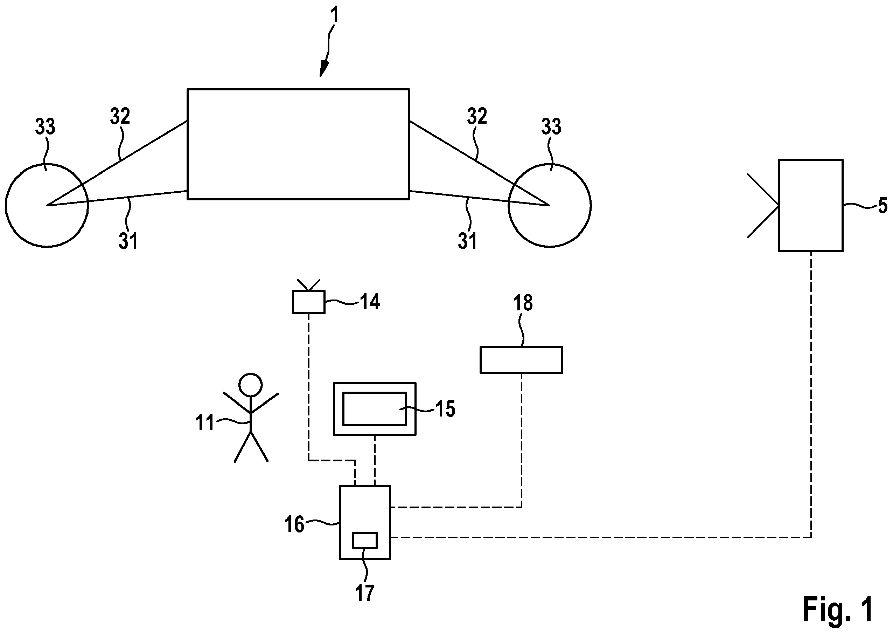

Die Figur 1 zeigt ein Kraftfahrzeug 1 in einer schematischen Darstellung bei dem nur die beiden Vorderräder 33 gezeigt sind. Die Vorderräder 33 sind durch eine Radaufnahme 31 und durch eine Spurstange 32 mit dem Kraftfahrzeug 1 verbunden.

Ein Anwender 11, im Ausführungsbeispiel ein Werkstatt-Mitarbeiter 11, führt einen oder mehrere Arbeitsschritte zur Durchführung von Einstellarbeiten am Kraftfahrzeug 1 durch. Der Anwender 11 nutzt ein System zur Durchführung von Einstellarbeiten, welches ihn bei den Arbeitsschritten am Kraftfahrzeug 1 unterstützt.

Das System weist eine Kamera 14 auf. Die Kamera 14 kann in einer Brille des Anwenders 11 integriert sein, so dass die Kamera 14 bei der Durchführung der Einstellarbeiten auf dieselben Fahrzeugdetails des Kraftfahrzeuges 1 gerichtet ist wie die Blickrichtung des Anwenders 11. Fahrzeugdetails können beispielsweise die Radaufnahme 31 und/oder die Spurstange 32 und/oder die Vorderräder 33 des Kraftfahrzeuges sein. Fahrzeugdetails können aber auch kleinere Bereiche der Spurstande 32 sein, z.B. die Einstellmutter, welche zur Veränderung der Spur vom Anwender oder Monteur gedreht werden muss.

Die Kamera 14 kann auch in einen tragbaren Rechner integriert sein. Der tragbare Rechner kann ein Laptop, ein Tablet oder ein Smartphone sein, welcher eine Kamera 14 aufweist. Der Anwender 11 muss in diesem Fall die Kamera 14 auf das Fahrzeugdetail des Kraftfahrzeuges 1 richten, an dem die Einstellarbeiten durchgeführt werden.

Die Kamera 14 nimmt während der Einstellarbeiten Bilder über ein oder mehrere Fahrzeugdetails auf und sendet die aufgenommenen Bilder an eine Datenverarbeitungseinheit 16, welche Bestandteil des Systems ist.

Das System weist des Weiteren einen Speicher 17 auf, welcher Dokumentationen und/oder Bilddokumentationen über die empfohlenen Arbeitsschritte bei der Durchführung von Einstellarbeiten enthält. Diese Dokumentationen können Texte sein, die in einem Wiedergabemittel 15 dargestellt werden und dem Anwender 11 darauf hinweisen, wie er bei den Einstellarbeiten vorgehen soll. Die Dokumentationen können auch Sprachanweisungen enthalten, die dem Anwender 11 über einen Lautsprecher oder ein Audioset darauf hinweisen, wie er bei den Einstellarbeiten vorgehen soll.

Der Speicher enthält auch Bildinformationen von Fahrzeugdetails von Kraftfahrzeugen 1 unterschiedlicher Typen.

Die Bildinformationen können Bilder des jeweiligen Kraftfahrzeuges 1 enthalten, in denen durch graphische Symbole, wie z.B. Pfeile oder Kreise, die Bauteile des Kraftfahrzeuges 1 hervorgehoben werden, an denen die nachfolgenden Arbeitsschritte durchgeführt werden müssen.

Das Wiedergabemittel 15 kann in einem Rechner als Bildschirm integriert sein. In einem alternativen Ausführungsbeispiel ist das Wiedergabemittel 15 eine Datenbrille, die der Anwender 11, während der Durchführung der Einstellarbeiten trägt.

Das System weist auch eine Achsvermessungseinrichtung 5 auf, welche Achsvermessungsdaten über die Vermessung des Kraftfahrzeuges 1 an die Datenverarbeitungseinheit 16 liefert.

Die Achsvermessungseinrichtung 5 führt Messungen an den Rädern 33 des Kraftfahrzeuges 1 durch und übermittelt Achsvermessungsdaten, z.B. Spur und/oder Sturzwerte, an die Datenverarbeitungseinheit 16.

Das System kann ein Eingabemittel 18 aufweisen, welches für die Interaktion eines Anwenders 11 mit dem System vorgesehen ist. Durch das Eingabemittel 18 kann der Anwender Informationen an die Datenverarbeitungseinheit 16 liefern. Dies kann z.B. eine Information über den Fahrzeugtyp zur Identifikation des Kraftfahrzeuges 1, an dem die Einstellarbeiten durchgeführt werden, sein.

Die Kamera 14, die Datenverarbeitungseinheit 16, der Speicher 17, das Wiedergabemittel 15 und das Eingabemittel 18 können in beliebiger Form kombiniert werden und in allen technisch bekannten Informationsverarbeitungsmittel integriert sein. Wichtig ist, dass der Anwender 11 die Kamera 14 auf die Fahrzeugdetails des Kraftfahrzeuges richten kann, an denen die Einstellarbeiten durchgeführt werden. Des Weiteren sollte der Anwender 11 während der Einstellarbeiten eine gute Sicht auf das Wiedergabemittel 15 haben, damit es dem Anwender 11 durch die Darstellung von Dokumentationen und/oder Bildern und/oder Bildinformation bei der Durchführung von Einstellarbeiten unterstützen kann.

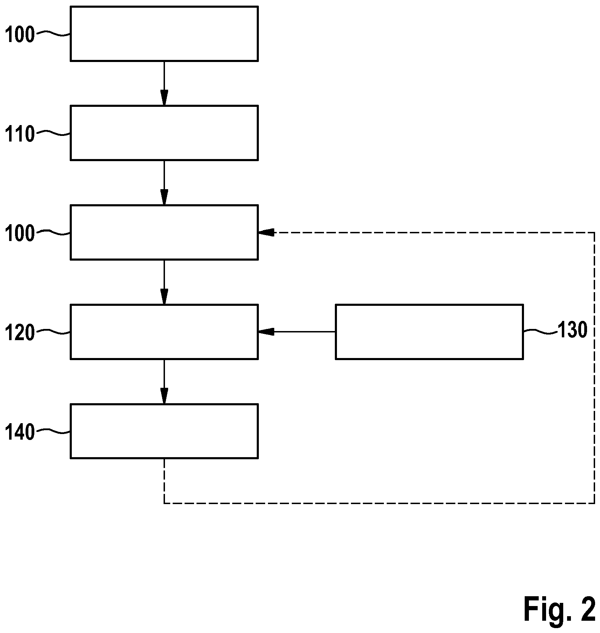

Figur 2 zeigt die durch das System durchgeführten Verfahrensschritte, welche einen Anwender 11 bei der Durchführung von Einstellarbeiten an einem Kraftfahrzeug 1 unterstützen sollen. Die Verfahrensschritte werden an einem Kraftfahrzeug 1 erläutert, an dem die Spur neu eingestellt werden soll.

Im Schritt 100 werden durch die Kamera 14 Bilder über Fahrzeugdetails aufgenommen. Da der Anwender 11 die Spur neu einstellen will, handelt es sich bei den Bildern um Aufnahmen des Rades 33 mit Radaufnahme 31 und Spurstange 32 oder um Detailaufnahmen aus den vorgenannten Gegenständen.

Im Schritt 110, werden die Bilder mit Bildinformationen über Fahrzeugdetails von Kraftfahrzeuge 1, die in dem Speicher 17 hinterlegt sind, verglichen, um eine Identifikation des Kraftfahrzeuges 1 durchzuführen. Die Identifikation kann beispielsweise anhand der Form und/oder Ausrichtung der Radaufnahme 31 und/oder der Spurstange 32 durchgeführt werden. Hierbei wird mit Hilfe von Bildverarbeitungsalgorithmen eine Zuordnung der Bilder zu hinterlegten Bildinformationen von einem Kraftfahrzeugtyp durchgeführt. Je nach Art der Einstellarbeiten reicht eine Zuordnung zu einer bestimmten Fahrwerksplattform oder Fahrzeugmarke.

Der Identifikation des Kraftfahrzeuges im Schritt 110 kann auch durch den Anwender 11 durchgeführt werden. Hierbei kann der Anwender 11 über das Eingabemittel 18 die benötigten Informationen zur Identifikation des Kraftfahrzeuges 1 eingeben.

Im Schritt 120 werden die durch die Kamera aufgenommenen Bilder und Achsvermessungsdaten, welche in einem Schritt 130 durch die Achsvermessungseinrichtung 5 aufgenommen wurden, durch die Datenverarbeitungseinheit 16 verarbeitet. Die Datenverarbeitungseinheit 16 erkennt das aktuelle Stadium der Einstellarbeiten am Kraftfahrzeug 1, indem es die durch die Kamera aufgenommenen Bilder über ein oder mehrere Fahrzeugdetails mit Bildinformationen über Fahrzeugdetails, die im Speicher 17 hinterlegt sind, vergleicht.

Im Schritt 130 vermisst die Achsvermessungseinrichtung 5 das Kraftfahrzeug 1, um relevante Achsvermessungsdaten für die Einstellarbeiten zu erhalten. Im aktuellen Beispiel handelt es sich um die Spurwerte des Kraftfahrzeuges 1, die nach der Achsvermessung an die Datenverarbeitungseinheit 16 übermittelt werden. Es können aber auch weitere Größen vermessen werden und die jeweiligen Daten an die Datenverarbeitungseinheit 16 gesendet werden.

Im Schritt 140 werden durch ein Wiedergabemittel 15 Dokumentationen und/oder Bilder und/oder Bildinformationen über die Einstellarbeiten und/oder nachfolgende Arbeitsschritte dargestellt. Diese informieren den Anwender 11 über den nächsten Arbeitsschritt, die Stelle an dem der Arbeitsschritt durchgeführt werden soll und den aktuellen Fortschritt seiner Arbeiten. So kann beispielsweise der aktuelle Spur-Wert, als Ist-Wert, und der für das Kraftfahrzeug benötigte Spur-Wert, als Soll-Wert, angezeigt werden. Der Anwender 11 kann durch Pfeile oder Kreise auf die Stelle hingewiesen werden, an der der nächste Arbeitsschritt durchgeführt werden soll und es können Texte eingeblendet werden, die den Anwender 11 über den nächsten Arbeitsschritt informieren.

Die Arbeitsschritte 100, 120 130 und 140 können beliebig oft wiederholt werden, bis das Wiedergabemittel 15 dem Anwender 11 mitteilt, dass als Spur-Wert der Soll-Wert erreicht wurde bzw. das keine Abweichung mehr zwischen dem Spur-Wert als Ist-Wert und dem Spur-Wert als Soll-Wert besteht.

Während der Einstellarbeiten kann eine periodische und/oder kontinuierliche und/oder wiederholte Vermessung des Kraftfahrzeuges 1 durch die Achsvermessungseinrichtung durchgeführt werden und die jeweiligen Achsvermessungsdaten an die Datenverarbeitungseinrichtung 16 gesendet werden.

Die Darstellung von Dokumentationen und/oder Bildern und/oder Bildinformationen über Einstellarbeiten und nachfolgende Arbeitsschritte in dem Wiedergabemittel 15 erfolgt abhängig von den jeweiligen Achsvermessungsdaten und/oder den jeweiligen Bildern über ein oder mehrere Fahrzeugdetails. Somit wird der Anwender abhängig vom Fortschritt seiner aktuellen Einstellarbeiten immer aktuell über den nächsten Arbeitsschritt informiert.

## Patentansprüche

1. System zur Durchführung von Einstellarbeiten an einem Kraftfahrzeug (1), insbesondere während einer Achsvermessung, mit
- mindestens einer Kamera (14) zur Aufnahme von Bildern über ein oder mehrere Fahrzeugdetails,
- mit einer Datenverarbeitungseinheit (16) zur Verarbeitung der durch die Kamera (14) aufgenommenen Bilder,
- mit einem Speicher (17), welcher Dokumentationen und/oder Bildinformationen über Einstellarbeiten an Kraftfahrzeugen (1) und/oder Bildinformationen von Fahrzeugdetails enthält,
- mit einem Wiedergabemittel (15) zur Darstellung von Dokumentationen und/oder Bildern und/oder Bildinformationen,
- mit einer Achsvermessungseinrichtung (5), welche das Kraftfahrzeug (1) vermisst und Achsvermessungsdaten an die Datenverarbeitungseinheit (16) liefert
- **dadurch gekennzeichnet, dass** die dargestellten Dokumentationen und/oder Bildinformationen über Einstellarbeiten den Anwender (11) über den nächsten Arbeitsschritt, die Stelle, an der der Arbeitsschritt durchgeführt werden soll, und den aktuellen Fortschritt seiner Arbeiten abhängig von den jeweiligen Achsvermessungsdaten und den jeweiligen Bildern informieren.

2. System nach Anspruch 1, wobei das Wiedergabemittel eine Datenbrille ist.

3. System nach Anspruch 2, wobei die Kamera (14) in die Datenbrille integriert ist.

4. System nach Anspruch 1, wobei ein Eingabemittel (18) zur Interaktion eines Anwenders (11) mit dem System vorgesehen ist.

5. System nach Anspruch 4, wobei das Eingabemittel (18) durch manuelle, visuelle und/oder auditive Interaktion steuerbar ist.

6. Verfahren zur Durchführung von Einstellarbeiten an einem Kraftfahrzeug (1), insbesondere während einer Achsvermessung, mit folgenden Schritten:
- Aufnehmen von Bildern über ein oder mehrere Fahrzeugdetails durch mindestens eine Kamera (14),
- Vergleich der Bilder mit Bildinformationen über Fahrzeugdetails von Kraftfahrzeugen in einer Datenverarbeitungseinheit (16), wobei die Bildinformationen in einem Speicher (17) hinterlegt sind,
- Vermessung des Kraftfahrzeuges (1) mit einer Achsvermessungseinrichtung (5) und übermitteln der Achsvermessungsdaten an die Datenverarbeitungseinheit (16),
- Darstellung von Dokumentationen und/oder Bildern und/oder Bildinformationen über Einstellarbeiten in dem Wiedergabemittel (15);
- **dadurch gekennzeichnet, dass** die dargestellten Dokumentationen und/oder Bildinformationen über Einstellarbeiten den Anwender (11) über den nächsten Arbeitsschritt, die Stelle, an der der Arbeitsschritt durchgeführt werden soll, und den aktuellen Fortschritt seiner Arbeiten abhängig von den jeweiligen Achsvermessungsdaten und den jeweiligen Bildern informieren.

7. Verfahren nach Anspruch 6, wobei ein Vergleich der Bilder mit Bildinformationen von Fahrzeugdetails unterschiedlicher Kraftfahrzeuge (1) durchgeführt wird, welcher zur Identifikation des Kraftfahrzeuges (1), an dem Einstellarbeiten durchgeführt werden, dient.

8. Verfahren nach Anspruch 7, wobei die Darstellung von Dokumentationen und/oder Bildern und/oder Bildinformationen über Einstellarbeiten und nachfolgende Arbeitsschritte unter Berücksichtigung der Identifikation des Kraftfahrzeuges (1) erfolgt.

9. Verfahren nach Anspruch 6, wobei es sich bei den Achsvermessungsdaten um Spurwerte und/oder Sturzwerte des Kraftfahrzeuges (1) handelt.

10. Verfahren nach einem der Ansprüche 6 bis 9, wobei eine periodische und/oder kontinuierliche und/oder wiederholte Vermessung des Kraftfahrzeuges (1) durch die Achsvermessungseinrichtung, während der Einstellarbeiten durchgeführt wird und die jeweiligen Achsvermessungsdaten an die Datenverarbeitungseinrichtung (16) gesendet werden.

11. Verfahren nach einem der Ansprüche 6 bis 10, wobei die Darstellung von Dokumentationen und/oder Bildern und/oder Bildinformationen über Einstellarbeiten und nachfolgende Arbeitsschritte in dem Wiedergabemittel (15) abhängig von den jeweiligen Achsvermessungsdaten und/oder den jeweiligen Bildern über ein oder mehrere Fahrzeugdetails aktualisiert werden.

## Claims

1. A system for performing adjustment operations on a motor vehicle (1), in particular during axle measurement, comprising:
- at least one camera (14) for recording images of one or more vehicle details,
- a data-processing unit (16) for processing the images recorded by the camera (14),
- a memory (17) storing documentation and/or image information about adjustment operations on motor vehicles (1) and/or image information of vehicle details,
- a reproduction device (15) for displaying documentation and/or images and/or image information,
- an axle-measuring device (15) which measures the motor vehicle (1) and supplies axle-measurement data to the data-processing unit (16),
- **characterised in that** the displayed documentation and/or image inform - ation pertaining to adjustment operations provide information to the user (11) about the next working step, the location where the working step is to be carried out, and the current progress of his operations as a function of the respective axle-measurement data and the respective images.

2. The system according to claim 1,
wherein the reproduction device is provided in the form of data glasses.

3. The system according to claim 2,
wherein the camera (14) is integrated in the data glasses.

4. The system according to claim 1,
wherein an input device (18) is provided for interaction between a user (11) and the system.

5. The system according to claim 4,
wherein the input device (18) is controllable by manual, visual and/or audit - ory interaction.

6. A method for performing adjustment operations on a motor vehicle (1), in particular during axle measurement, the method comprising the following steps:
- recording images of one or more vehicle details by means of at least one camera (14),
- comparing the images with image information regarding vehicle details of motor vehicles in a data-processing unit (16), the image information being stored in a memory (17),
- measuring the motor vehicle (1) by means of an axle-measuring device (5) and transmitting the axle-measurement data to the data-processing unit (16),
- displaying documentation and/or images and/or image information per - taining to adjustment operations in the reproduction device (15),
- **characterized in that** the displayed documentation and/or image inform - ation pertaining to adjustment operations provide information to the user (11) about the next working step, the location where the working step is to be carried out, and the current progress of his operations as a function of the respective axle-measurement data and the respective images.

7. The method according to claim 6,
wherein a comparison of the images with image information of vehicle de - tails of different motor vehicles (1) is carried out which serves for identifica - tion of the motor vehicle (1) on which the adjustment operations are per - formed.

8. The method according to claim 7,
wherein the display of documentation and/or images and/or image informa - tion about adjustment operations and subsequent working steps takes place taking the identification of the motor vehicle (1) into account.

9. The method according to claim 8,
wherein the axle-measurement data are track values and/or camber values of the motor vehicle (1).

10. The method according to any of claims 6 to 9,
wherein periodic, continuous and/or repeated measuring of the motor vehicle (1) by the axle-measuring device takes place while the adjustment operations are carried out and the respective axle-measurement data are transmitted to the data-processing unit (16).

11. The method according to any of claims 6 to 10,
wherein the display of documentation and/or image information pertaining to adjustment operations and subsequent working steps are updated in the re - production device (15) as a function of the respective axle-measurement data and/or the respective images of one or more vehicle details.

## Revendications

1. Système pour réaliser des opérations de réglage sur un véhicule automobile (1), en particulier au cours d'une mesure d'essieux, avec
- au moins une caméra (14) pour la capture d'images d'un ou de plusieurs détails du véhicule automobile,
- avec une unité de traitement de données (16) permettant de traiter les images capturées par la caméra (14),
- avec une mémoire (17) qui contient des documentations et/ou des informations d'images sur des opérations de réglage réalisées sur des véhicules automobiles (1) et/ou des informations d'images de détails de véhicules automobiles,
- avec un moyen de restitution (15) permettant de représenter des documentations et/ou des images et/ou des informations d'images,
- avec un dispositif de mesure d'essieux (5) qui mesure le véhicule automobile (1) et livre des données de mesure d'essieux à l'unité de traitement de données (16),
- **caractérisé en ce que** les documentations et/ou les informations d'images représentées concernant les opérations de réglage informent l'opérateur (11) sur l'étape de travail suivante, l'endroit où l'étape de travail doit être effectuée ainsi que l'avancement actuel de ses travaux en fonction des données de mesure d'essieux et des images correspondantes.

2. Système selon la revendication 1, dans lequel le moyen de restitution sont des lunettes de données.

3. Système selon la revendication 2, dans lequel la caméra (14) est intégrée aux lunettes de données.

4. Système selon la revendication 1, dans lequel est prévu un moyen d'entrée (18) pour l'interaction d'un opérateur (11) avec le système.

5. Système selon la revendication 4, dans lequel le moyen d'entrée (18) peut être commandé par l'intermédiaire d'une interaction manuelle, visuelle et/ou auditive.

6. Procédé pour réaliser des opérations de réglage sur un véhicule automobile (1), en particulier au cours d'une mesure d'essieux, comprenant les étapes suivantes :
- capture d'images d'un ou de plusieurs détails du véhicule automobile par au moins une caméra (14),
- comparaison des images par rapport à des informations d'images de détails de véhicules automobiles dans une unité de traitement de données (16), sachant que les informations d'images sont stockées dans une mémoire (17),
- mesure du véhicule automobile (1) avec un dispositif de mesure d'essieux (5) et transmission des données de mesure d'essieux à l'unité de traitement de données (16),
- représentation de documentations et/ou d'images et/ou d'informations d'images des opérations de réglage dans le moyen de restitution (15) ;
- **caractérisé en ce que** les documentations et/ou les informations d'images représentées sur les opérations de réglage informent l'opérateur (11) sur l'étape de travail suivante, l'endroit où l'étape de travail doit être effectuée et l'avancement actuel de ses travaux en fonction des données de mesure d'essieux et des images correspondantes.

7. Procédé selon la revendication 6, dans lequel une comparaison des images par rapport aux informations d'images de détails de différents véhicules automobiles (1) est effectuée afin de permettre l'identification du véhicule automobile (1) sur lequel sont réalisées les opérations de réglage.

8. Procédé selon la revendication 7, dans lequel la représentation de documentations et/ou d'images et/ou d'informations d'images des opérations de réglage et des étapes de travail suivantes se fait en tenant compte de l'identification du véhicule automobile (1).

9. Procédé selon la revendication 6, dans lequel les données de mesure d'essieux concernent des valeurs de parallélisme et/ou des valeurs de carrossage du véhicule automobile (1).

10. Procédé selon l'une quelconque des revendications 6 à 9, dans lequel une mesure périodique et/ou continue et/ou répétée du véhicule automobile (1) est effectuée par le dispositif de mesure d'essieux pendant les opérations de réglage et dans lequel les données de mesure d'essieux respectives sont envoyées au dispositif de traitement de données (16).

11. Procédé selon l'une quelconque des revendications 6 à 10, dans lequel la représentation de documentations et/ou d'images et/ou d'informations d'images des opérations de réglage et les étapes de travail suivantes sont actualisées dans le moyen de restitution (15) en fonction des données de mesure d'essieux correspondantes et/ou des images correspondantes d'un ou de plusieurs détails du véhicule automobile.
